# EUROPÄISCHE PATENTSCHRIFT

(11) **EP 2 050 189 B1**
(45) Veröffentlichungstag und Bekanntmachung des Hinweises auf die Patenterteilung: **09.07.2014**
(21) Anmeldenummer: 07788106.8
(22) Anmeldetag: 01.08.2007
(51) Int. Cl.: H03K 17/965

(54) **BEDIENELEMENT**
OPERATING ELEMENT
ÉLÉMENT DE COMMANDE

(30) Priorität: 01.08.2006 DE 102006035837
(43) Veröffentlichungstag der Anmeldung: 22.04.2009
(73) Patentinhaber: Continental Automotive GmbH, 30165 Hannover (DE)
(72) Erfinder: WÜSTENBECKER, Dirk, 35614 Asslar (DE)
(86) Internationale Anmeldenummer: PCT/EP2007/057934
(87) Internationale Veröffentlichungsnummer: WO 2008/015225

(56) Entgegenhaltungen:
- WO-A-2005/008003
- DE-A1- 2 744 206
- GB-A- 2 091 489

## Beschreibung

Die Erfindung bezieht sich auf ein Bedienelement, insbesondere für eine Kraftfahrzeugkomponente, mit einem auf einem linear beweglichen Trägerelement angeordneten Betätigungselement, das eine plattenartige, auf seiner einen Plattenseite manuell beaufschlagbare Tastplatte aus einem elektrisch nicht leitenden Material aufweist, durch das ein Schaltelement betätigbar ist und in dem ein elektrisch leitendes Sensorelement eines kapazitiven Näherungssensors angeordnet ist, das elektrisch leitend mit einer Leiterplatte verbunden ist.

Zur Bedienung von Kraftfahrzeugkomponenten, wie zum Beispiel eines Radiogerätes, eines Navigationsgerätes, eines Autotelefons, einer Multimediaanlage und dergleichen, werden häufig Bedien- und Anzeigeeinrichtungen eingesetzt, die im Fahrzeug ergonomisch angeordnet sind. Die Anzeigeeinrichtung sollte dabei so angeordnet werden, dass der Fahrer diese mit einer möglichst geringen Ablenkung vom Straßenverkehr erfassen kann. Die Anzeigeeinheit wird daher vorzugsweise im Bereich des Armaturenbrettes oder im oberen Bereich einer Mittelkonsole angeordnet. Die Bedieneinheit wird vorzugsweise so angeordnet, dass der Fahrer diese mit den Fingern ohne größere Armbewegung erreichen kann. Diese Anordnung der Bedieneinheit hat jedoch den Nachteil, dass die Bedieneinheit optisch nur sehr schlecht erfasst werden kann. Der Fahrer wird daher die Bedienelemente der Bedieneinheit häufig ohne Sichtkontakt ertasten und auswählen. Es ist daher wünschenswert, die Annäherung einer Hand des Fahrers an ein Bedienelement zu erfassen, um so beispielsweise in der Anzeigeeinrichtung einen Hinweis auf die Art des Bedienelementes bzw. die damit zu bedienende Funktion oder auch eine akustische Rückmeldung ausgeben zu können, bevor das Bedienelement betätigt und die damit verknüpfte Aktion ausgeführt wird.

Aus der DE 27 44 206 A1 und der GB-A-2 091 489 sind kapazitive Tastschalter bekannt.

Aus der WO 2005/008003 A ist ein Griff für Türen an Fahrzeugen bekannt, der voneinander räumlich getrennt einen kapazitiven Näherungssensor und einen Tastschalter aufweist.

Aufgabe der Erfindung ist es ein Bedienelement der eingangs genannten Art zu schaffen, durch das mit einem hohen Maß an Sicherheit die Annäherung einer Hand an das Bedienelement erfassbar ist.

Diese Aufgabe wird erfindungsgemäß dadurch gelöst, dass das Sensorelement des Näherungssensors an oder in der das Sensorelement des Näherungssensors an der der einen Plattenseite gegenüberliegenden zweiten Plattenseite der Tastplatte angeordnet ist und durch eine Feder in Anlage an die der einen Plattenseite gegenüberliegende zweite Plattenseite der Tastplatte beaufschlagt ist.

Durch diese Ausbildung kann die Hand unabhängig von Herstellungstoleranzen der Bauteile des Bedienelements immer sehr dicht an das Sensorelement des Näherungssensors herangeführt werden, so dass eine Erfassung der sich nähernden Hand mit großer Sicherheit erfolgt.

Es ist auch möglich bei ansonsten baugleichen Bedienelementen unterschiedliche Betätigungselemente zu verwenden, da das Sensorelement des Näherungssensors sich immer an optimaler Position befindet.

Insbesondere können die Betätigungselemente unterschiedliche Länge besitzen.

Durch die Anordnung des Sensorelements an der der einen Plattenseite gegenüberliegenden zweiten Plattenseite der Tastplatte werden Beschädigungen vermieden.

In dem Betätigungselement des Bedienelementes ist ein elektrisch leitendes Sensorelement (Sensorelektrode) eines kapazitiven Näherungssensors angeordnet, das elektrisch leitend mit einer Leiterplatte verbunden ist. Durch die Anordnung des Sensorelementes in dem Betätigungselement ist das Sensorelement für den Benutzer nicht sichtbar und beeinträchtigt somit in keiner Weise das optische Erscheinungsbild des Bedienelementes. Durch die entsprechende elektrisch leitende Verbindung des Sensorelementes mit der Leiterplatte kann ein Sensorsignal des Sensorelementes in einfacher Weise zu signalverarbeitenden Elementen weitergeleitet werden, die insbesondere auf der Leiterplatte selbst angeordnet sind. Durch geeignete Anordnung des Sensorelementes in dem Betätigungselement und geeignete Verbindung mit der Leiterplatte kann erreicht werden, dass die herkömmliche Funktionalität des Bedienelementes, insbesondere eines Drucktasters, nicht beeinträchtigt wird.

In Doppelfunktion der Feder kann das Sensorelement durch die Feder elektrisch leitend mit der Leiterplatte verbunden sein.

Dabei ist vorzugsweise die Feder eine Druckfeder.

Diese Feder kann eine Schraubendruckfeder sein.

Ist die Feder ein zieharmonikaartiges Federelement, das aus zwei oder mehreren Falten zueinander bildenden Blechteilen besteht, so können Betätigungselemente großer unterschiedlicher Länge bei ansonsten gleichem Aufbau des Bedienelements verwendet werden.

In einfacher Ausbildung ist das Sensorelement ein Metallelement oder ein metallisch beschichtetes Kunststoffelement und kann als Sensorplatte ausgebildet sein.

Entspricht die Form der an der Tastplatte anliegenden Fläche der Sensorplatte der Form der zweiten Plattenseite der Sensorplatte, so ist die gesamte Sensorplatte optimiert nahe zur ersten Plattenseite der Tastplatte angeordnet.

Dies ermöglicht es ohne Verlust der Sensorsensibilität auch Tastplatten mit von einer Ebene abweichender Form wie z.B. gewölbter Oberfläche zu verwenden.

Eine einfache Steckmontage wird dadurch ermöglicht, dass das Betätigungselement topfartig ausgebildet und mit seiner Topföffnung auf das Trägerelement aufgesetzt ist, wobei der Boden des Topfes die Tastplatte bildet.

Dabei kann das Betätigungselement unterschiedliche Querschnitte wie z.B. rechteckig oder rund besitzen.

Einfach herstellbar ist es, wenn das Trägerelement ein rahmenartiges Blech-/Biegeteil ist, das entgegen einer Federkraft aus einer Normalposition in eine Schaltposition bewegbar ist.

Dabei kann in Steckmontage das topfartige Betätigungselement auf das Trägerelement aufsteckbar und insbesondere durch Fixierelemente haltbar sein.

Ist das Betätigungselement kraftschlüssig auf dem Trägerelement haltbar, so können durch variable Aufschiebtiefe Herstellungstoleranzen kompensiert werden. Dies ist insbesondere bei mehreren vorzugsweise gleichen Bedienelementen eines Gerätes von Vorteil.

Dazu kann das Trägerelement quer zu einer Bewegungsrichtung hervorstehende Rastelemente aufweisen, die mit federnder Vorspannung an der Topfwand des Betätigungselementes in Anlage sind.

Sind die Rastelemente quer zur Bewegungsrichtung abgebogene Ausklinkungen des Trägerelementes, so ergibt sich eine erhebliche Reduzierung der Bauteile und des Montageaufwandes.

Das Trägerelement kann an einer Blende entgegen der Federkraft aus der Normalposition in die Schaltposition bewegbar angeordnet sein, die die Leiterplatte abdeckt.

Weist dabei die Blende eine Öffnung auf, in die das auf dem Trägerelement angeordnete Betätigungselement eintauchend bewegbar ist, so bildet die Öffnung gleichzeitig eine Führung für das Bedienelement.

Die Federkraft kann auf dem Bewegungsweg des Betätigungselementes zwischen der Normalposition und der Schaltposition ein Maximum aufweisen, so dass erst nach Überwindung des Maximums der Federkraft und damit einem vollständigen Bewegen des Betätigungselementes in die Schaltposition eine Betätigung des Schaltelementes erfolgt. Ein unabsichtliches Betätigen des Schaltelementes wird so weitgehend vermieden.

Um das unbetätigte Betätigungselement in seiner Normalposition zu halten sowie nach einer Betätigung in die Normalposition zurückzubewegen, kann das Trägerelement über ein oder mehrere Federarme an der Blende oder einem mit der Blende verbundenen Bauteil angeordnet sein.

Bauteil- und Montageaufwand reduzierend können die Federarme einteilig mit dem Trägerelement als Blech-/Biegebauteil ausgebildet sein.

In Doppelfunktion kann durch die Federarme in der Schaltposition das Schaltelement betätigbar sein.

Das leitende Trägerelement weist vorzugsweise eine Kontaktzunge auf, die mit einem Kontakt der Leiterplatte elektrisch leitend verbunden ist, wobei die Kontaktzunge Bau- und Montageaufwand reduzierend einteilig mit dem Trägerelement als Blech-/Biegebauteil ausgebildet sein kann.

Besonders wenige Bauteile sind erforderlich, wenn Feder, Trägerelement und Kontaktzunge elektrisch leitend ausgebildet sind und eine elektrisch leitende Verbindung des Sensorelements mit der Leiterplatte bilden.

Dies führt auch zu einer geringen Baugröße des Bedienelements.

Ohne ein zusätzliches Bauraumerfordernis ist eine Beleuchtung der Tastplatte möglich, wenn die Bauteile des Bedienelements eine durchgehende Lichtöffnung aufweisen, an deren der Tastplatte entgegengesetztem Ende eine Lichtquelle angeordnet ist, durch die ein transparenter Bereich der Tastplatte durchleuchtbar ist.

Zur guten Lichtausnutzung und gleichmäßigen Lichtverteilung kann dabei die innere Umfangsfläche des Trägerelements eine Reflektionsbeschichtung aufweisen.

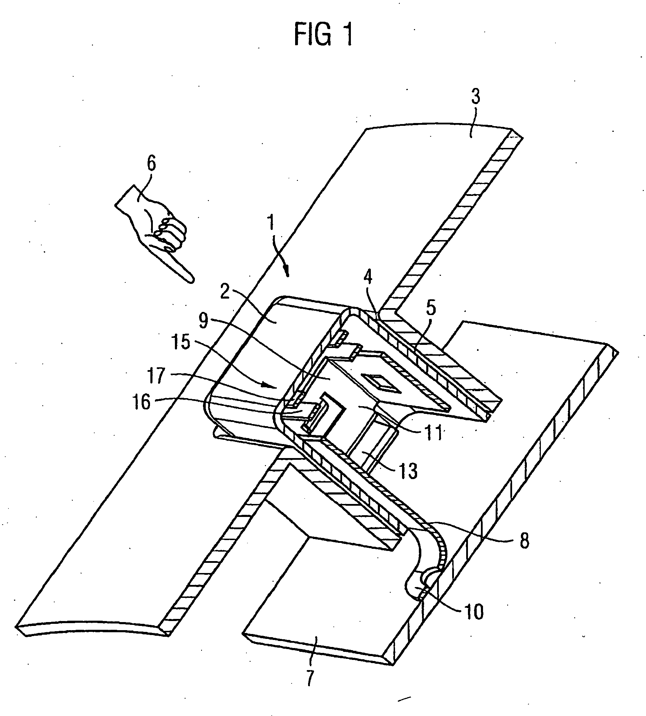

Ein Ausführungsbeispiel der Erfindung ist in der Zeichnung dargestellt und wird im Folgenden näher beschrieben. Es zeigen
- Figur 1: einen perspektivischen Querschnitt durch ein Bedienelement;

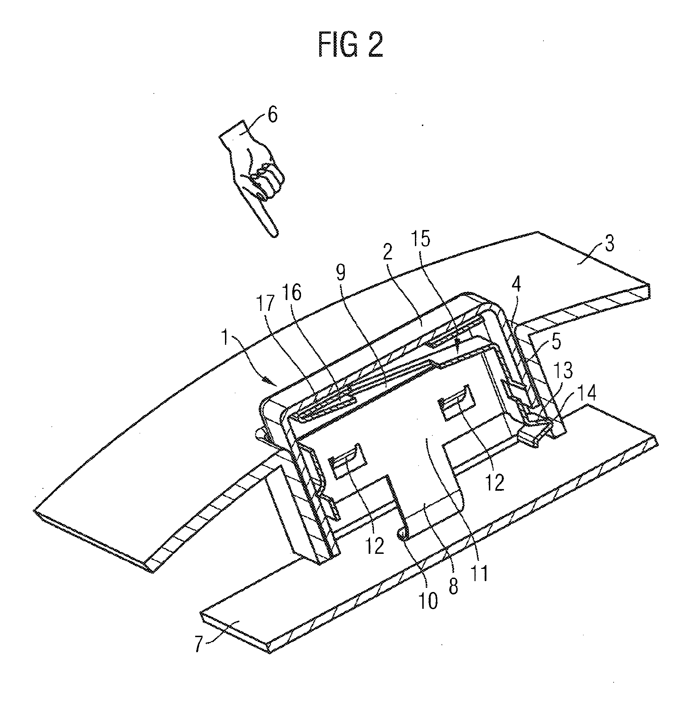

- Figur 2: einen perspektivischen Längsschnitt durch das Bedienelement nach Figur 1;

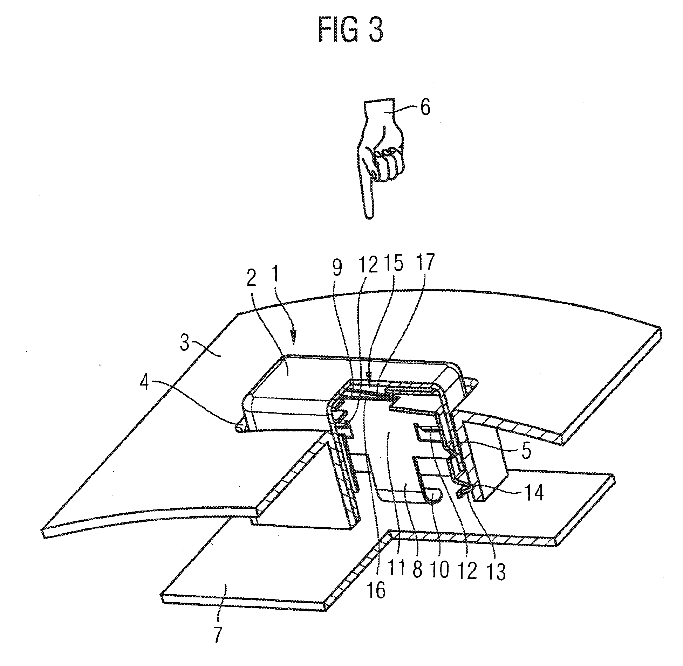

- Figur 3: eine perspektivische Ansicht des Bedienelements nach Figur 1 in einem Teilschnitt und

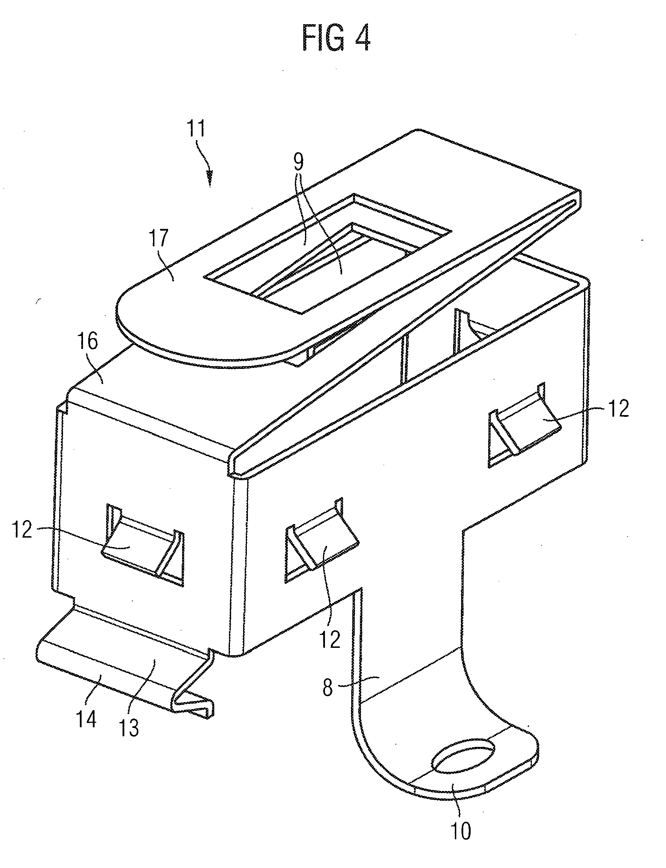

- Figur 4: eine perspektivische Ansicht eines Trägerelements des Bedienelements nach Figur 1.

An einer feststehenden Blende 3 ist eine Öffnung 4 ausgebildet, von der ein Führungsschacht 5 zu der der Betätigungsseite entgegengesetzten Seite ausgeht. Die Betätigungsseite ist symbolisch durch eine Betätigungshand 6 dargestellt. Der Führungsschacht 5 reicht bis zu einer etwa parallel zur Blende 3 freistehend angeordneten Leiterplatte 7.

Eine sich senkrecht zur Leiterplatte 7 erstreckende Kontaktzunge 8 eines Trägerelements 11 liegt mit ihrem abgebogenen Ende 10 auf einer nicht dargestellten Leiterbahn der Leiterplatte 7 auf und ist mit der Leiterplatte 7 fest verbunden.

Die gleichzeitig eine Rückstellfeder bildende Kontaktzunge 8 ist einteilig mit einem rahmenartigen, als Blech-/Biegeteil ausgebildeten Trägerelement 11 ausgebildet, das in den Führungsschacht 5 hineinragt. Von der Betätigungsseite her ist ein topfartiges Betätigungselement 1 auf das Trägerelement 11 aufgesetzt, dessen Boden eine von einer Bedienungsperson beaufschlagbare Tastplatte 2 bildet und das in den Führungsschacht 5 ragt und darin verschiebbar geführt ist.

Zur Befestigung des Betätigungselements 1 auf dem Trägerelement 11 weist das Trägerelement 11 quer zur Bewegungsrichtung des Betätigungselements 11 abgebogene Ausklinkungen 12 an seinen Rahmenseiten auf, die an den Innenwänden des Betätigungselements 1 mit federnder Vorspannung anliegen und so eine kraftschlüssige Verbindung bilden.

Da die Ausklinkungen 12 der Leiterplatte 7 hin geneigt sind, kann das Betätigungselement 1 stufenlos in die jeweils gewünschte Position auf das Trägerelement 11 aufgeschoben werden.

Ebenfall einteilig mit dem Trägerelement 9 ist an dessen zur Leiterplatte 7 gerichteten Seite ein Federarm 13 ausgebildet, der eine etwa parallel zur Leiterplatte 7 gerichtete V-förmige Abbiegung 14 aufweist, die mit ihrer V-Spitze mit Vorspannung an einer Wand des Führungsschachts 5 in Anlage ist.

Das zur Leiterplatte 7 gerichtete freie Ende des Federarms 13 bildet einen Kontakt, der bei Beaufschlagung des Betätigungselements 1 und Verschiebung von Betätigungselement 1 und Trägerelement 11 in Richtung zur Leiterplatte 7 hin ein auf der Leiterplatte 7 angeordnetes, nicht dargestelltes Schaltelement betätigt.

An dem der Tastplatte 2 zugewandten Ende des Trägerelements 11 ist mit diesem einteilig eine ziehharmonikaartiges Federelement 15 ausgebildete Feder angeordnet, die aus zwei V-förmig miteinander verbundenen Platten 16 und 17 besteht, von denen die der Leiterplatte 7 nähere Platte 16 mit ihrem der Verbindung mit der anderen Platte 17 entgegengesetzten Ende mit dem Rahmen des Trägerelements 11 verbunden ist.

Die Platte 17 bildet eine Sensorplatte eines kapazitiven Näherungssensors.

Durch die Federkraft des Federelements 15 wird dessen die Sensorplatte bildende Platte 17 immer in flächiger Anlage an der Tastplatte 2 gehalten.

Damit befindet sich die Sensorplatte in einer nächstmöglichen Position zu der das Bedienelement beaufschlagenden Betätigungshand 6 und kann zu einem frühen Zeitpunkt vor Berührung des Betätigungselements 1 durch die Betätigungshand 6 bereits eine folgende Betätigung des Bedienelements sensieren.

In den Platten 16 und 17 sind Lichtöffnungen 9 ausgebildet, durch die mittels einer nicht dargestellten auf der Leiterplatte 7 angeordneten und in das Trägerelement 11 ragenden Lichtquelle die ganz oder teilweise durchleuchtbare Tastplatte 2 hinterleuchtbar ist.

## Patentansprüche

1. Bedienelement, insbesondere für eine Kraftfahrzeugkomponente, mit einem auf einem linear beweglichen Trägerelement angeordneten Betätigungselement, das eine plattenartige, auf seiner einen Plattenseite manuell beaufschlagbare Tastplatte aus einem elektrisch nicht leitenden Material aufweist, durch das ein Schaltelement betätigbar ist und in dem ein elektrisch leitendes Sensorelement eines kapazitiven Näherungssensors angeordnet ist, das elektrisch leitend mit einer Leiterplatte verbunden ist, **dadurch gekennzeichnet, dass** das Sensorelement des Näherungssensors an der der einen Plattenseite gegenüberliegenden zweiten Plattenseite der Tastplatte (2) angeordnet ist und durch eine Feder in Anlage an die der einen Plattenseite gegenüberliegende zweite Plattenseite der Tastplatte (2) beaufschlagt ist.

2. Bedienelement nach Anspruch 1, **dadurch gekennzeichnet, dass** das Sensorelement durch die Feder elektrisch leitend mit der Leiterplatte (7) verbunden ist.

3. Bedienelement nach einem der vorhergehenden Ansprüche, **dadurch gekennzeichnet, dass** die Feder eine Druckfeder ist.

4. Bedienelement nach Anspruch 3, **dadurch gekennzeichnet, dass** die Feder eine Schraubendruckfeder ist.

5. Bedienelement nach Anspruch 3, **dadurch gekennzeichnet, dass** die Feder ein zieharmonikaartiges Federelement (15) ist.

6. Bedienelement nach einem der vorhergehenden Ansprüche, **dadurch gekennzeichnet, dass** das Sensorelement ein Metallelement oder ein metallisch beschichtetes Kunststoffelement ist.

7. Bedienelement nach Anspruch 6, **dadurch gekennzeichnet, dass** das Sensorelement als Sensorplatte (17) ausgebildet ist.

8. Bedienelement nach Anspruch 7, **dadurch gekennzeichnet, dass** die Form der an der Tastplatte (2) anliegenden Fläche der Sensorplatte (17) der Form der zweiten Plattenseite der Tastplatte (2) entspricht.

9. Bedienelement nach einem der vorhergehenden Ansprüche, **dadurch gekennzeichnet, dass** das Betätigungselement (1) topfartig ausgebildet und mit seiner Topföffnung auf das Trägerelement (11) aufgesetzt ist, wobei der Boden des Topfes die Tastplatte (2) bildet.

10. Bedienelement nach einem der vorhergehenden Ansprüche, **dadurch gekennzeichnet, dass** das Trägerelement (11) ein rahmenartiges Blech-/Biegeteil ist, das entgegen einer Federkraft aus einer Normalposition in eine Schaltposition bewegbar ist.

11. Bedienelement nach den Ansprüchen 9 und 10, **dadurchge kennzeichnet**, dass das topfartige Betätigungselement (1) auf das Trägerelement (11) aufsteckbar und insbesondere durch Fixierelemente haltbar ist.

12. Bedienelement nach Anspruch 11, **dadurch gekennzeichnet, dass** das Betätigungselement (1) kraftschlüssig auf dem Trägerelement (11) haltbar ist.

13. Bedienelement nach einem der Ansprüche 11 und 12, **dadurch gekennzeichnet, dass** das Trägerelement (11) quer zu einer Bewegungsrichtung hervorstehende Rastelemente aufweist, die mit federnder Vorspannung an der Topfwand des Betätigungselements (1) in Anlage sind.

14. Bedienelement nach Anspruch 13, **dadurch gekennzeichnet, dass** die Rastelemente quer zur Bewegungsrichtung abgebogene Ausklinkungen (12) des Trägerelements (11) sind.

15. Bedienelement nach einem der vorhergehenden Ansprüche, **dadurch gekennzeichnet, dass** das Trägerelement (11) an einer Blende (3) entgegen der Federkraft aus der Normalposition in die Schaltposition bewegbar angeordnet ist.

16. Bedienelement nach Anspruch 15, **dadurch gekennzeichnet, dass** die Blende (3) eine Öffnung (4) aufweist, in die das auf dem Trägerelement (11) angeordnete Betätigungselement (1) eintauchend bewegbar ist.

17. Bedienelement nach einem der Ansprüche 15 und 16, **dadurch gekennzeichnet, dass** die Federkraft auf dem Bewegungsweg des Betätigungselements zwischen der Normalposition und der Schaltposition ein Maximum aufweist.

18. Bedienelement nach einem der Ansprüche 15 bis 17, **dadurch gekennzeichnet, dass** das Trägerelement (11) über ein oder mehrere Federarme (13) an der Blende (3) oder ein mit der Blende verbundenes Bauteil angeordnet ist.

19. Bedienelement nach Anspruch 18, **dadurch gekennzeichnet, dass** die Federarme (13) einteilig mit dem Trägerelement (11) als Blech-/Biegebauteil ausgebildet sind.

20. Bedienelement nach einem der Ansprüche 18 und 19, **dadurch gekennzeichnet, dass** durch die Federarme (13) in der Schaltposition das Schaltelement betätigbar ist.

21. Bedienelement nach Anspruch 10, **dadurch gekennzeichnet, dass** das Trägerelement (11) eine Kontaktzunge (8) aufweist, die mit einem Kontakt der Leiterplatte (7) elektrisch leitend verbunden ist.

22. Bedienelement nach Anspruch 21, **dadurch gekennzeichnet, dass** die Kontaktzunge (8) einteilig mit dem Trägerelement (11) als Blech-/Biegebauteil ausgebildet ist.

23. Bedienelement nach einem der vorhergehenden Ansprüche, **dadurch gekennzeichnet, dass** Feder, Trägerelement (11) und Kontaktzunge (8) elektrisch leitend ausgebildet sind und eine elektrisch leitende Verbindung des Sensorelements mit der Leiterplatte (7) bilden.

24. Bedienelement nach einem der vorhergehenden Ansprüche, **dadurch gekennzeichnet, dass** die Bauteile des Bedienelements eine durchgehende Lichtöffnung (9) aufweisen, an deren der Tastplatte (2) entgegengesetztem Ende eine Lichtquelle angeordnet ist, durch die ein transparenter Bereich der Tastplatte (2) durchleuchtbar ist.

25. Bedienelement nach den Ansprüchen 10 und 24, **dadurch gekennzeichnet, dass** die innere Umfangsfläche des Trägerelements eine Reflektionsbeschichtung aufweist.

## Claims

1. Operating element, in particular for a motor vehicle component, having an activation element which is arranged on a linearly movable carrier element and has a plate-like touch plate, which can be acted on manually on its one plate side, is composed of an electrically non-conductive material, can activate a switching element and has an electrically conductive sensor element of a capacitive proximity sensor arranged in it, said sensor element being connected in an electrically conductive fashion to a printed circuit board, **characterized in that** the sensor element of the proximity sensor is arranged on the second plate side of the touch plate (2), lying opposite the one plate side, and is pressed into abutment against the second plate side of the touch plate (2), lying opposite the one plate side, by a spring.

2. Operating element according to Claim 1, **characterized in that** the sensor element is connected in an electrically conductive fashion to the printed circuit board (7) by the spring.

3. Operating element according to one of the preceding claims, **characterized in that** the spring is a compression spring.

4. Operating element according to Claim 3, **characterized in that** the spring is a helical compression spring.

5. Operating element according to Claim 3, **characterized in that** the spring is a concertina-like spring element (15).

6. Operating element according to one of the preceding claims, **characterized in that** the sensor element is a metal element or a metallically coated plastic element.

7. Operating element according to Claim 6, **characterized in that** the sensor element is embodied as a sensor plate (17).

8. Operating element according to Claim 7, **characterized in that** the shape of the face of the sensor plate (17) which bears on the touch plate (2) corresponds to the shape of the second plate side of the touch plate (2).

9. Operating element according to one of the preceding claims, **characterized in that** the activation element (1) is embodied in the manner of a pot and is fitted with its pot opening onto the carrier element (11), wherein the bottom of the pot forms the touch plate (2).

10. Operating element according to one of the preceding claims, **characterized in that** the carrier element (11) is a frame-like sheet metal/bent part which can be moved from a normal position into a switched position counter to a spring force.

11. Operating element according to Claims 9 and 10, **characterized in that** the pot-like activation element (1) can be plugged onto the carrier element (11) and held, in particular, by securing elements.

12. Operating element according to Claim 11, **characterized in that** the activation element (1) can be held on the carrier element (11) in a frictionally locking fashion.

13. Operating element according to one of Claims 11 and 12, **characterized in that** the carrier element (11) has latching elements which protrude transversely with respect to a direction of movement and bear with spring prestressing against the pot wall of the activation element (1).

14. Operating element according to Claim 13, **characterized in that** the latching elements are tabs (12) of the carrier element (11) which are bent out transversely with respect to the direction of movement.

15. Operating element according to one of the preceding claims, **characterized in that** the carrier element (11) is arranged on a panel (3) in such a way that it can be moved from the normal position into the switched position counter to the spring force.

16. Operating element according to Claim 15, **characterized in that** the panel (3) has an opening (4) into which the activation element (1) which is arranged on the carrier element (11) can be moved in such a way that it dips therein.

17. Operating element according to one of Claims 15 and 16, **characterized in that** the spring force is at a maximum on the movement path of the activation element between the normal position and the switched position.

18. Operating element according to one of Claims 15 to 17, **characterized in that** the carrier element (11) is arranged by means of one or more spring arms (13) on the panel (3) or a component connected to the panel.

19. Operating element according to Claim 18, **characterized in that** the spring arms (13) are formed in one piece with the carrier element (11) as a sheet-metal/bent component.

20. Operating element according to one of Claims 18 and 19, **characterized in that** the switching element can be activated by the spring arms (13) in the switched position.

21. Operating element according to Claim 10, **characterized in that** the carrier element (11) has a contact tongue (8) which is connected in an electrically conductive fashion to a contact of the printed circuit board (7).

22. Operating element according to Claim 21, **characterized in that** the contact tongue (8) is embodied in one piece with the carrier element (11) as a sheet-metal/bent component.

23. Operating element according to one of the preceding claims, **characterized in that** the spring, carrier element (11) and contact tongue (8) are embodied in an electrically conductive fashion and form an electrically conductive connection of the sensor element to the printed circuit board (7).

24. Operating element according to one of the preceding claims, **characterized in that** the components of the operating element have a continuous light opening (9), at the end of which opposite the touch plate (2) a light source is arranged, by means of which light source a transparent region of the touch plate (2) can be illuminated.

25. Operating element according to Claims 10 and 24, **characterized in that** the internal circumferential face of the carrier element has a reflective coating.

## Revendications

1. Elément de commande, notamment pour un composant de véhicule automobile, comprenant un élément d'actionnement monté sur un élément de support, mobile linéairement et ayant une plaque de manipulation, en un matériau non conducteur de l'électricité de type en plaque, qui peut être manipulé manuellement sur l'une de ses faces, par laquelle un élément de commutation peut être actionné et dans laquelle est monté un élément conducteur de l'électricité d'un capteur capacitif de proximité, qui est relié d'une manière conductrice de l'électricité à une plaquette à circuit imprimé, **caractérisé en ce que** l'élément du capteur de proximité est disposé sur la deuxième face, opposée à la une face, de la plaque (2) de manipulation et est, par un ressort, mis en contact avec la deuxième face, opposée à la première face, de la plaque (2) de manipulation.

2. Elément de commande suivant la revendication 1, **caractérisé en ce que** l'élément du capteur est, par le ressort, relié d'une manière conductrice de l'électricité à la plaquette (7) à circuit imprimé.

3. Elément de commande suivant l'une des revendications précédentes, **caractérisé en ce que** le ressort est un ressort de compression.

4. Elément de commande suivant la revendication 3, **caractérisé en ce que** le ressort est un ressort hélicoïdal.

5. Elément de commande suivant la revendication 3, **caractérisé en ce que** le ressort est un élément (15) de ressort de type en accordéon.

6. Elément de commande suivant l'une des revendications précédentes, **caractérisé en ce que** l'élément du capteur est un élément métallique ou un élément en matière plastique revêtu de métal.

7. Elément de commande suivant la revendication 6, **caractérisé en ce que** l'élément de capteur est constitué sous la forme d'une plaque (17) formant capteur.

8. Elément de commande suivant la revendication 7, **caractérisé en ce que** la forme de la surface s'appliquant à la plaque (2) de manipulation de la plaque (17) formant capteur correspond à la forme de la deuxième face de la plaque (2) de manipulation.

9. Elément de commande suivant l'une des revendications précédentes, **caractérisé en ce que** l'élément (1) d'actionnement est constitué en forme de pot et est posé par son ouverture de pot sur l'élément (11) de support, le fond du pot formant la plaque (2) de manipulation.

10. Elément de commande suivant l'une des revendications précédentes, **caractérisé en ce que** l'élément (11) de support est une pièce cintrée de tôle de type en cadre qui peut, à l'encontre d'une force de ressort, passer d'une position normale à une position de commutation.

11. Elément de commande suivant les revendications 9 et 10, **caractérisé en ce que** l'élément (1) d'actionnement en forme de pot peut être enfilé sur l'élément (11) de support en étant maintenu, notamment, par des éléments d'immobilisation.

12. Elément de commande suivant la revendication 11, **caractérisé en ce que** l'élément (1) d'actionnement peut être maintenu à coopération de force sur l'élément (11) de support.

13. Elément de commande suivant l'une des revendications 11 et 12, **caractérisé en ce que** l'élément (11) de support a des éléments d'encliquetage, qui sont en saillie transversalement à une direction de déplacement et qui sont en contact avec précontrainte élastique avec la paroi du pot de l'élément (1) d'actionnement.

14. Elément de commande suivant la revendication 13, **caractérisé en ce que** les éléments d'encliquetage sont des cliquets (12) de l'élément (11) de support, coudés transversalement à la direction de déplacement.

15. Elément de commande suivant l'une des revendications précédentes, **caractérisé en ce que** l'élément (11) de support est monté sur un écran (3), à l'encontre de la force d'un ressort, mobile de la position normale à la position de commutation.

16. Elément de commande suivant la revendication 15, **caractérisé en ce que** l'écran (3) à une ouverture (4) dans laquelle peut pénétrer l'élément (1) d'actionnement monté sur l'élément (11) de support.

17. Elément de commande suivant l'une des revendications 15 et 16, **caractérisé en ce que** la force du ressort a un maximum sur le trajet de déplacement de l'élément d'actionnement entre la position normale et la position de commutation.

18. Elément de commande suivant l'une des revendications 15 à 17, **caractérisé en ce que** l'élément (11) de support est, par un ou par plusieurs bras (13) de ressort, monté sur l'écran (13) ou sur une pièce reliée à l'écran.

19. Elément de commande suivant la revendication 18, **caractérisé en ce que** les bras (13) de ressort sont constitués d'une seule pièce avec l'élément (11) de support sous la forme d'une pièce de tôle cintrée.

20. Elément de commande suivant l'une des revendications 18 et 19, **caractérisé en ce que** l'élément de commutation peut être actionné dans la position de commutation par les bras (13) de ressort.

21. Elément de commande suivant la revendication 10, **caractérisé en ce que** l'élément (11) de support a une languette (18) de contact, qui est reliée d'une manière conductrice de l'électricité avec un contact de la plaquette (7) à circuit imprimé.

22. Elément de commande suivant la revendication 21, **caractérisé en ce que** la languette (8) de contact est constituée d'une seule pièce avec l'élément (11) de support sous la forme d'une pièce de tôle cintrée.

23. Elément de commande suivant l'une des revendications précédentes, **caractérisé en ce que** le ressort, l'élément (11) de support et la languette (8) de contact sont conducteurs de l'électricité et forment une liaison conductrice de l'électricité du capteur avec la plaquette (7) à circuit imprimé.

24. Elément de commande suivant l'une des revendications précédentes, **caractérisé en ce que** les pièces de l'élément de commande ont une fenêtre traversante, à l'extrémité opposée à la plaque (2) de manipulation de laquelle est disposée une source lumineuse par laquelle une partie transparente de la plaque (2) de manipulation peut être éclairée.

25. Elément de commande suivant l'une des revendications 10 et 24, **caractérisé en ce que** la surface périphérique intérieure de l'élément de support a un revêtement réfléchissant.
